# EUROPEAN PATENT APPLICATION

(11) **EP 1 610 370 A2**
(43) Date of publication of application: **28.12.2005**
(21) Application number: 05253754.5
(22) Date of filing: 16.06.2005
(51) Int. Cl.: H01L 21/322, H01L 29/32

(54) **Semiconductor device, and fabrication method of semiconductor device**

(30) Priority: 16.06.2004 JP 2004178205
(71) Applicant: SHARP KABUSHIKI KAISHA, Osaka 545-8522 (JP)
(72) Inventor: Arimura, Motoharu, Fukuyama-shi Hiroshima 721-0904 (JP)
(74) Representative: Brown, Kenneth Richard

(57) **Abstract**

The semiconductor device according to the invention comprises a semiconductor substrate having a semiconductor integrated circuit on the front face thereof and a micro-defect layer preformed in the inside, wherein the semiconductor substrate is made as thin as 150 µm or thinner in the thickness from the back face so as to leave the micro-defect layer.

## Description

### BACKGROUND OF THE INVENTION

### 1. Field of the Invention

The invention relates to a semiconductor device and a fabrication method of the semiconductor device.

### 2. Description of Related Art

Along with high intensification of semiconductor devices in recent years, LSI devices each provided with a composite function have been required. Also, with respect to memory devices, composite chips having increased capacities and multi-functions have been required. To satisfy these requirements, semiconductor devices are layered in three to five layers or more in a single LSI package in some cases. In such a case, the thickness of the substrate of the respective semiconductor devices is required to be thinner than 150 µm.

With respect to a device such as an IC card, the thickness of the card is determined to be 0.84 mm as the maximum by ISO standards or the like and the thickness of the substrate of a semiconductor device to be assembled in the IC card module has to be thinner than 150 µm.

As described above, in relation to the multifunctional property of the semiconductor devices required for LSI devices of the future and module forms required for IC cards or the like, it is required for a semiconductor device to use a thin substrate polished to be 150 µm or thinner and to have a high reliability.

As methods for providing semiconductor devices with substrate thickness as thin as desired, there are methods described in JP-A 1-270216 (1989) and JP-A 62-93981 (1987). These methods involve polishing semiconductor integrated circuits to a prescribed thickness by mechanical polishing methods and then removing the processed layers of the polished faces. The removal methods include those characterized in that the removal is carried out by solely wet or dry process and others characterized in that steps of mechanically polishing one surface of a semiconductor substrate to 150 µm or thinner and chemically etching the mechanically polished surface for removing the strained layer of the surface.

However, thin type semiconductor devices fabricated by the above-mentioned fabrication methods have sometimes been deteriorated in their characteristic properties at the time of sealing with resins and, therefore, the yield of the resin-sealing process cannot be made high.

### SUMMARY OF THE INVENTION

The present invention has been achieved in view of the aforementioned circumstances and provides a thin type semiconductor device with improved yield in the resin-sealing process.

The semiconductor device according to the invention comprises a semiconductor substrate having a semiconductor integrated circuit on the front face thereof and a micro-defect layer preformed in the inside, wherein the semiconductor substrate is made as thin as 150 µm or thinner in the thickness from the back face so as to leave the micro-defect layer.

Inventors of the invention have found that in the case of a semiconductor device comprising a semiconductor substrate made as thin as 150 µm or thinner, heavy metals such as iron and nickel penetrate the substrate from the rear face of the substrate in the resin-sealing process and sometimes contaminate a semiconductor integrated circuit on the front face of the substrate to deteriorate the characteristics of the semiconductor device. Based on the findings, the inventors have found that the semiconductor integrated circuit can be protected from heavy metal contamination even in the resin-sealing process by previously forming a micro-defect layer in the substrate and have accomplished the invention.

Accordingly, the invention provides a thin type semiconductor device with high reliability and the yield in the resin-sealing process can be improved.

### BRIEF DESCRIPTION OF THE DRAWINGS

The present invention will become more fully understood from the detailed description given hereinbelow and the accompanying drawings which are given by way of illustration only, and thus are not limitative of the present invention and wherein:
Fig. 1 is a cross-sectional view showing the structure of a semiconductor device according to a first embodiment of the invention;
Fig. 2 is a cross-sectional view showing the fabrication process of the semiconductor device according to the first embodiment of the invention;
Fig. 3 is a cross-sectional view showing the fabrication process of the semiconductor device according to the first embodiment of the invention;
Fig. 4 is a cross-sectional view showing the fabrication process of the semiconductor device according to the first embodiment of the invention;
Fig. 5 is a cross-sectional view showing a fabrication process of the semiconductor device according to the second embodiment of the invention;
Fig. 6 is a cross-sectional view showing the fabrication process of the semiconductor device according to the first embodiment of the invention;
Fig. 7 is a cross-sectional view showing the fabrication process of the semiconductor device according to the first embodiment of the invention; and
Fig. 8 is a cross-sectional view showing the fabrication process of the semiconductor device according to the first embodiment of the invention.

### DESCRIPTION OF THE PREFERRED EMBODIMENTS

### 1. Structure of semiconductor device

A semiconductor device according to the invention comprises a semiconductor substrate having a semiconductor integrated circuit on the front face thereof and a micro-defect layer preformed in the inside, wherein the semiconductor substrate is made as thin as 150 µm or thinner in the thickness from the back face so as to leave the micro-defect layer.

### 1-1. Semiconductor substrate

As the semiconductor substrate, an element semiconductor substrates such as Si, Ge, or the like or a compound semiconductor substrates such as GaAs or the like can be used. The semiconductor substrate may be a single crystal or polycrystalline. The semiconductor substrate is preferably a single crystal substrate of Si. The semiconductor substrate is preferably provided with an epitaxial layer on the surface.

The semiconductor substrate is made as thin as 150 µm or thinner in the thickness. With respect to the semiconductor substrate made so thin, heavy metal contamination in the resin sealing process tends to be a problem, however according to the invention, especially a semiconductor integrated circuit can be prevented from damages by the contamination.

### 1-2. Semiconductor integrated circuit

The semiconductor integrated circuit is formed on the substrate. The semiconductor integrated circuit is a circuit in which memories, transistors or the like are integrated. The semiconductor integrated circuit generally comprises at least one layer of a gate oxide film and at least one layer of a gate electrode layer.

### 1-3. Micro-defect layer

The micro-defect layer is formed in the substrate. The micro-defect layer is preferably formed in a region in 10 µm or deeper depth from the front face of the substrate. The micro-defect layer has function of getting heavy metals penetrating the substrate from the back face of the substrate (working as a getter site to the heavy metals) and preventing contamination of the semiconductor integrated circuit whatever position in the substrate it is formed in. However, if the micro-defect layer is formed in the vicinity of the front face of the substrate, the micro-defect layer itself sometimes deteriorates the properties of the semiconductor integrated circuit. Accordingly, the micro-defect layer is preferable to be formed in the region in 10 µm or deeper depth from the front face of the substrate.

The micro-defect layer is preferable to have a defect density of 1 × 10⁴ to 3 × 10⁵/cm². If the defect density is too low, the effect as the getter site is insufficient and if the defect density is too high, it increases current leakage and causes a defect, so-called slip. The defect density of the micro-defect layer generally has a certain distribution in the thickness direction of the substrate, and the "defect density" in the above-mentioned numeral range is based on the maximum value of the distribution.

### 1-4. Making substrate thin

The substrate is made thin from the back face in a manner that the micro-defect layer is left and the thickness is adjusted to be 150 µm or thinner. It will be described more in detail later.

### 2. Semiconductor device fabrication method

A semiconductor device fabrication method according to the invention comprises the steps of: forming a micro-defect layer in the inside of a semiconductor substrate; forming a semiconductor integrated circuit on the substrate; and making the substrate as thin as 150 µm or thinner in the thickness from the back face of the substrate so as to leave the micro-defect layer.

### 2-1. Step of forming micro-defect layer in semiconductor substrate

A substrate has a thickness exceeding 150 µm. The thickness of the substrate is generally about 500 to 1000 µm. The micro-defect layer is formed in the semiconductor substrate. The micro-defect layer is preferably formed in a region in 150 µm or shallower depth from the front face of the semiconductor substrate. The micro-defect layer is preferably formed in a region in 10 µm or thicker depth from the front face of the semiconductor substrate.

Conventionally, the micro-defect layer is formed in the vicinity of the back face of the semiconductor substrate with a thickness of about 700 µm and is not formed in the vicinity of the front face of the substrate. The reason for that is because it is supposed that if the micro-defect layer is formed in the vicinity of the front face of the substrate, the micro-defect layer would cause adverse effects on the properties of the semiconductor integrated circuit to be formed in the process carried out thereafter. The micro-defect layer formed in the vicinity of the back face is removed when the semiconductor substrate is made thin to 150 µm or thinner in the back face polishing process after formation of the semiconductor integrated circuit. Therefore, in a conventional semiconductor device fabrication method, no micro-defect layer is left after the back face polishing. The invention makes the micro-defect layer remain even after making the semiconductor substrate thin and thus fabricates a semiconductor device in which the semiconductor integrated circuit is protected from heavy metal contamination from the back face of the substrate.

The micro-defect layer formed in the invention remains, as described above, even after the substrate is made thin. Accordingly, the micro-defect layer is formed in the shallower region than the region corresponding to the back face after the substrate is made thin.

The micro-defect layer is preferably formed so as to have the defect density of 1 × 10⁴ to 3 × 10⁵/cm².

The micro-defect layer is formed by heating the substrate in oxygen gas atmosphere or an oxygen-nitrogen mixed gas atmosphere. The temperature and duration of the heat treatment may properly be changed, so that the depth in which the micro-defect layer is formed can be adjusted. Also, the partial pressure of oxygen may be properly changed, so that the defect density of the micro-defect layer can be adjusted.

The micro-defect layer can be formed by implanting oxygen ion in the substrate. The depth in which the micro-defect layer is formed can be adjusted by properly changing the ion implantation energy. Also, the defect density of the micro-defect layer can be adjusted by properly changing the quantity of the oxygen ion to be implanted.

The micro-defect layer can be formed by other various known methods. The depth and the defect density of the micro-defect layer can be adjusted by methods other than those described above.

### 2-2. Step of forming semiconductor integrated circuit on substrate

The semiconductor integrated circuit is formed before or after formation of the micro-defect layer. To prevent heavy metal contamination during formation of the semiconductor integrated circuit, the semiconductor integrated circuit is preferable to be formed after formation of the micro-defect layer.

### 2-3. Step of making substrate as thin as 150 µm or thinner in the thickness from back face so as to leave micro-defect layer

The substrate is made thin from the back face of the substrate in a manner that the micro-defect layer is left and the thickness is adjusted to be 150 µm or thinner. The substrate is preferably made thin so as to expose the micro-defect layer in the back face.

In this case, the micro-defect layer is formed at position sufficiently apart from the semiconductor integrated circuit to avoid adverse effects of the micro-defect layer on the semiconductor integrated circuit.

The substrate is made thin preferably by mechanical polishing. The substrate is made thin further preferably by mechanical polishing and successive wet or dry etching. Although a stress strained layer is formed in the back face of the substrate by the mechanical polishing, the layer is removed by etching and therefore warping of a wafer or the like can be moderated. The wet etching may be carried out using an aqueous NaOH or KOH solution. The dry etching can be carried out by, for example, a polishing method.

By the above-mentioned steps, a semiconductor device comprising the semiconductor substrate, a semiconductor integrated circuit formed on the substrate, and a micro-defect layer formed in the substrate and having 150 µm thickness of the substrate can be obtained.

### 3. Others

The above detailed descriptions of the structure of the semiconductor device are applicable to ones of the above semiconductor device fabrication method, unless contrary to the spirit.

### (First Embodiment)

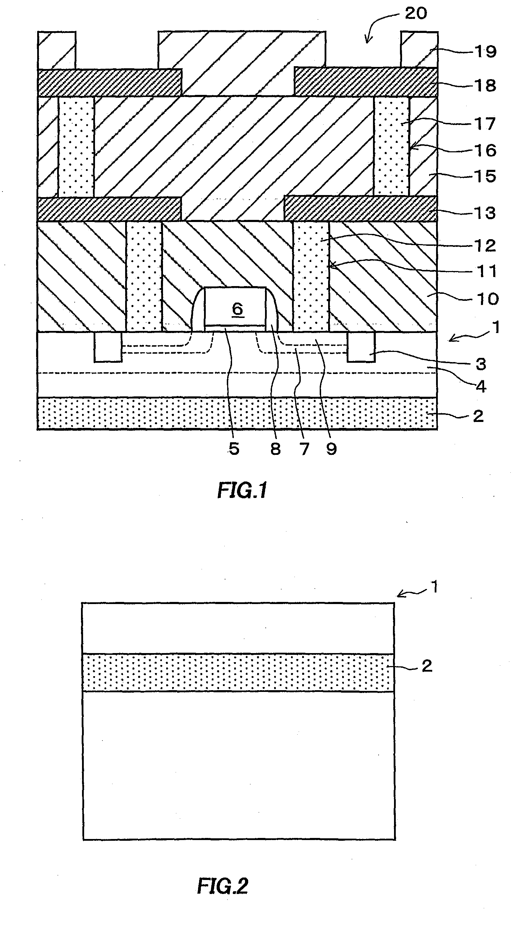

Hereinafter, a first embodiment of the invention will be described along with drawings. Fig. 1 is a cross-sectional view showing the structure of a semiconductor device comprising a thin substrate according to this embodiment of the invention.

### 1. Structure of semiconductor device

The semiconductor device of this embodiment comprises a semiconductive Si substrate 1, a semiconductor integrated circuit formed on the substrate 1, and a micro-defect layer 2 formed in the substrate, and the substrate 1 has a thickness of 150 µm or thinner. The micro-defect layer 2 is formed in the vicinity of the back face of the substrate 1. As the semiconductor integrated circuit, a gate insulating film 5, a gate electrode 6 formed thereon, a side wall 8 formed on the side face of the gate electrode 6, an LDD region 7 formed closely to the gate electrode 6, and a source/drain region 9 are formed on the substrate 1. Further, an interlayer insulating film 10, a connection hole 11 filled with a connection wiring metal material 12 and formed in the interlayer insulating film 10, and metal wiring 13 arranged on the interlayer insulating film 10 are formed on the substrate 1. Further, another interlayer insulating film 15, a connection hole 16 filled with a connection wiring metal material 17 and formed in the interlayer insulating film 15, and metal wiring 18 arranged on the interlayer insulating film 15 are formed on the interlayer insulating film 10. Further, cover glass 19 having a Pad connection hole 20 is formed on the interlayer insulating film 15.

### 2. Semiconductor device fabrication method

Hereinafter, the semiconductor device fabrication method according to this embodiment will be described along with Figs. 2 to 8. Figs. 2 to 8 are cross-sectional views showing the fabrication processes of the semiconductor device of the invention.

At first, the micro-defect layer 2 is formed in the region of 150 µm or shallower depth from the front face of the semiconductive Si substrate 1 having the thickness of 500 to 1000 µm to obtain the structure shown in Fig. 2. As shown in Fig. 2, the micro-defect layer 2 is formed in the front face side (top side) of the substrate 1. The defect density of the micro-defect layer is adjusted to be 1 × 10⁴ to 3 × 10⁵/cm². The micro-defect layer 2 is formed in a Si wafer by heating a CZ Si substrate at high temperature, 1100°C or higher, in oxygen partial pressure (oxygen or oxygen/nitrogen atmosphere) and thereby diffusing oxygen outward. In this case, the temperature and the duration of the heat treatment are adjusted, so that the depth of the micro-defect layer 2 from the front face and the defect density of the micro-defect layer 2 can be adjusted.

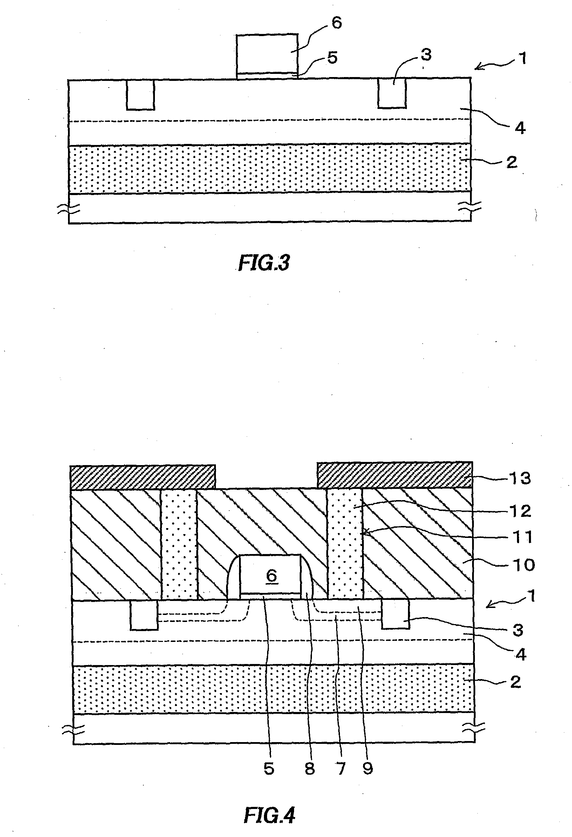

Next, as shown in Fig. 3, an element isolation region 3 is arranged in the front face part of the Si substrate 1. The element isolation region 3 can be formed by an STI (Shallow Trench Isolation) method or a LOCOS method using a thermal oxidation film. The thickness of the substrate 1 and the position of the micro-defect layer 2 shown in Fig. 3 are the same as those in Fig. 2. Accordingly, the part under the micro-defect layer 2 in Fig. 3 actually has the same thickness as that in Fig. 2. It is also true to Figs. 4 to 7.

Successively, a transistor structure is formed in the active region on the substrate. At first, using a resist mask, well injection is carried out to form a well region 4 and a gate oxidation film 5 is formed. The thickness of the gate oxidation film 5 may be 3 to 20 nm as commonly employed.

Next, the gate electrode 6 is disposed. The line width of the gate electrode 6 may be 0.13 to 1.0 µm. The steps from the well 4 formation to the gate electrode 6 formation may be performed in a different order. That is, the well 4 formation may be carried out after formation of the gate oxide film 5 and the gate electrode 6 by performing well injection with an injection energy considering the thickness of the gate electrode 6

Successively, as shown in Fig. 4, using the gate electrode 6 as a mask, the LDD region 7 is formed. Further, in the side wall part of the gate electrode 6, the side wall film 8 is formed in self-alignment manner and ion implantation is carried out to form a high density source/drain region 9. After that, a salicide structure may be formed in self-alignment manner in the top part of the gate electrode 6 and the source/drain region 9 of the transistor.

Following that, the first interlayer insulating film 10 is formed on the entire region of the front face of the Si substrate 1. To make the transistor actively operable, the hole 11 for connecting to the wiring is formed in the interlayer insulating film. Although the hole 11 is disposed only in the source/drain part 9 in the figure, a connection hole to the gate electrode 6 is also formed. A metal material 12 such as tungsten for making electric connection possible is packed in the connection hole 11. Successively, the first metal wiring 13 is formed on the interlayer insulating film 10 for operating the transistor.

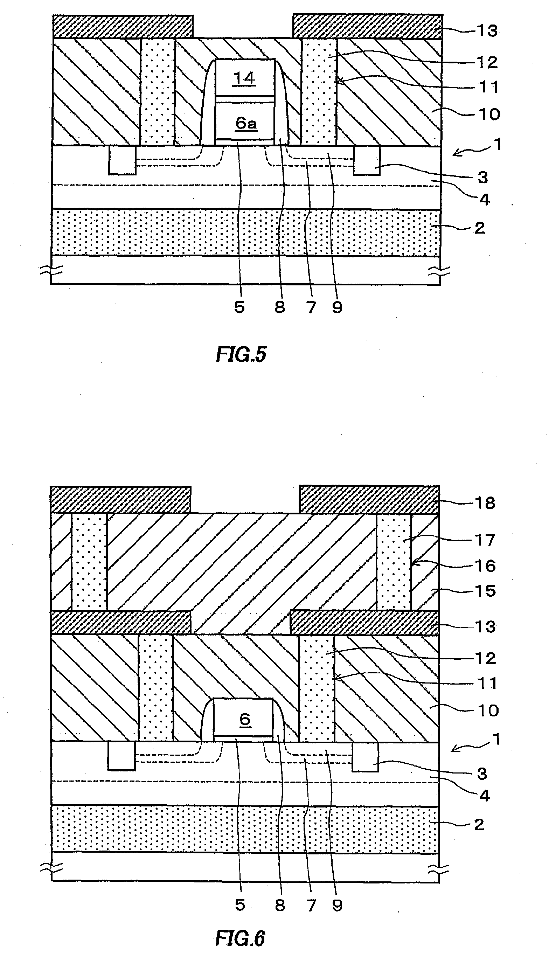

The above-mentioned transistor may have either structure of an NMOS transistor or a PMOS transistor. As shown in Fig. 5, a memory device comprising a first gate electrode (a floating gate electrode) 6a of a non-volatile memory and a second gate electrode (a control gate electrode) 14 on the floating gate electrode 6a in place of the gate electrode 6 may be used (Second Embodiment).

As shown in Fig. 6, the second interlayer insulating film 15 is formed on the first metal wiring 13; the connection hole 16 is formed in the second interlayer insulating film 15; a metal material 17 such as tungsten for making electric connection possible is packed in the connection hole 16; and the second metal wiring 18 is formed on the second interlayer insulating film 15. The steps shown in Fig. 6 may be repeated thereafter to form five or six layers of the metal wiring layers.

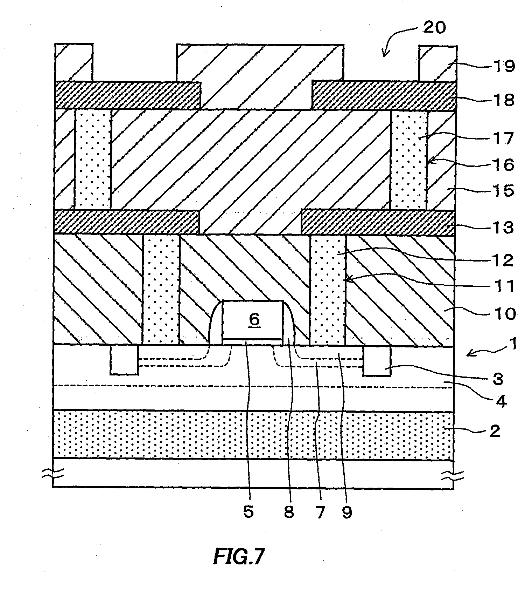

As shown in Fig. 7, the cover glass 19 is formed on the entire surface of the top part of the metal wiring 18 in the uppermost layer and a hole 20 is formed in the cover glass 19 for forming connection of the metal wiring 18 with the outside of the semiconductor device.

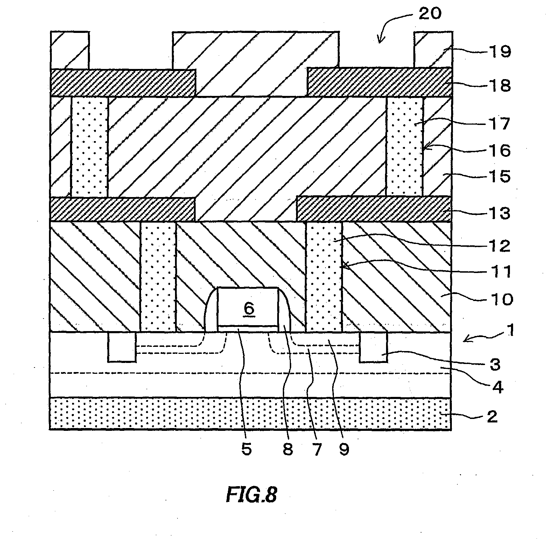

As shown in Fig. 8, the back face of the Si substrate 1 in which the above-mentioned semiconductor integrated circuit is formed is mechanically polished by a grinder capable of carrying out thin polishing to make the thickness of the substrate to 150 µm or thinner. The micro-defect layer 2 remains in the Si substrate 1 even after the polishing. In this embodiment, the micro-defect layer 2 is exposed in the back face of the substrate 1.

After that, to moderate the warping of the wafer, the stress strained layer may be eliminated by etching with an etching solution of such as NaOH or KOH.

Fabrication of the semiconductor device with the above-mentioned structure can prevent deterioration of reliability of the semiconductor device attributed to contamination with heavy metals such as iron and nickel from the back face of the semiconductor device in the case of using the semiconductor device in layers in an LSI package or in the case of sealing the semiconductor device with resin in a module just like an IC card module.

The invention thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A semiconductor device comprising a semiconductor substrate having a semiconductor integrated circuit on the front face thereof and a micro-defect layer preformed in the inside, wherein
the semiconductor substrate is made as thin as 150 µm or thinner in the thickness from the back face so as to leave the micro-defect layer.

2. The device of claim 1, wherein
the micro-defect layer is formed in a region with a depth of 10 µm or deeper from the front face of the substrate.

3. The device of claim 1, wherein
the micro-defect layer has a defect density of 1 × 10⁴ to 3 × 10⁵/cm².

4. The device of claim 1, wherein
the substrate is made thin in a manner that the micro-defect layer is exposed in the back face.

5. The device of claim 1, wherein
the substrate is made thin by mechanical polishing.

6. The device of claim 1, wherein
the substrate is made thin by mechanical polishing and successive wet or dry etching.

7. The device of claim 1, wherein
the semiconductor integrated circuit comprises at least one layer of a gate oxide film and at least one layer of a gate electrode layer.

8. A semiconductor device fabrication method comprising the steps of:
forming a micro-defect layer in the inside of a semiconductor substrate;
forming a semiconductor integrated circuit on the substrate; and
making the substrate as thin as 150 µm or thinner in the thickness from the back face of the substrate so as to leave the micro-defect layer.

9. The method of claim 8, wherein
the micro-defect layer is formed in a region with a depth of 10 µm or deeper from the front face of the semiconductor substrate.

10. The method of claim 8, wherein
the substrate is made thin so as to expose the micro-defect layer in the back face.

11. The method of claim 8, wherein
the substrate is made thin by mechanical polishing.

12. The method of claim 8, wherein
the substrate is made thin by mechanical polishing and successive wet or dry etching.

13. The method of claim 8, wherein
the semiconductor integrated circuit comprises at least one layer of a gate oxide film and at least one layer of a gate electrode layer.
